(19) Europäisches Patentamt
European Patent Office
Office européen des brevets

(11) **EP 2 134 887 B1**

(12) **EUROPÄISCHE PATENTSCHRIFT**

(45) Veröffentlichungstag und Bekanntmachung des Hinweises auf die Patenterteilung:
**18.05.2011 Patentblatt 2011/20**

(21) Anmeldenummer: **08716322.6**

(22) Anmeldetag: **06.03.2008**

(51) Int Cl.:
*C23C 18/16* (2006.01)   *C25D 5/02* (2006.01)
*C25D 7/12* (2006.01)   *H01L 21/288* (2006.01)

(86) Internationale Anmeldenummer:
**PCT/EP2008/001807**

(87) Internationale Veröffentlichungsnummer:
**WO 2008/107194 (12.09.2008 Gazette 2008/37)**

(54) **VERFAHREN ZUR PRÄZISIONSBEARBEITUNG VON SUBSTRATEN UND DESSEN VERWENDUNG**

METHOD FOR THE PRECISION PROCESSING OF SUBSTRATES AND USE OF SAID METHOD

PROCÉDÉ DE TRAITEMENT DE PRÉCISION DE SUBSTRATS, ET SON UTILISATION

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **06.03.2007 DE 102007010872**

(43) Veröffentlichungstag der Anmeldung:
**23.12.2009 Patentblatt 2009/52**

(73) Patentinhaber:
 • **Fraunhofer-Gesellschaft zur Förderung der angewandten Forschung e.V.**
   **80686 München (DE)**
 • **Albert-Ludwigs-Universität Freiburg**
   **79085 Freiburg (DE)**

(72) Erfinder:
 • **MAYER, Kuno**
   **79114 Freiburg (DE)**
 • **ALEMAN, Monica**
   **1040 Brüssel (BE)**
 • **KRAY, Daniel**
   **79098 Freiburg (DE)**
 • **GLUNZ, Stefan**
   **79111 Freiburg (DE)**
 • **METTE, Ansgar**
   **04105 Leipzig (DE)**
 • **PREU, Ralf**
   **79117 Freiburg (DE)**
 • **GROHE, Andreas**
   **79108 Freiburg (DE)**

(74) Vertreter: **Riepe, Hans-Gerd**
   **Pfenning, Meinig & Partner GbR**
   **Patent- und Rechtsanwälte**
   **Theresienhöhe 13**
   **D-80339 München (DE)**

(56) Entgegenhaltungen:
   DE-A1-102005 032 807     GB-A- 2 188 774
   JP-A- 10 212 585     US-A- 4 639 378
   US-A1- 2003 172 969     US-A1- 2004 242 019
   US-A1- 2005 003 594     US-B1- 6 429 037

 • **J. WANG ET AL: "Laser-induced selective deposition of Ni-P alloy on silicon" APPLIED SURFACE SCIENCE, Bd. 84, 1995, Seiten 383-389, XP002521839**

## Beschreibung

Die Erfindung betrifft ein Verfahren zur simultanen Mikrostrukturierung, Dotierung und zumindest bereichsweisen Aufbringung einer Keimschicht, insbesondere zur Mikrostrukturierung von dünnen Schichten, der lokalen Dotierstoffeinbringung sowie der lokalen Aufbringung einer Metallkeimschicht, bei dem ein flüssigkeitsunterstützter Laser, d.h. eine Laserbestrahlung eines Substrats, das in den zu bearbeitenden Bereichen von einer geeigneten reaktiven Flüssigkeit bedeckt ist, durchgeführt wird. Je nach Anwendung können dabei die Flüssigkeit, die Laserquelle sowie die Verfahrensparameter angepasst werden. Insbesondere lässt sich das Verfahren mit verschiedenen Laser-Chemie-Kombinationen für die Solarzellen-Prozessierung verwenden, wobei dielektrische Schichten mikrostrukturiert werden und gleichzeitig oder nacheinander zusätzlich eine lokale Dotierung und eine Keimschichtabscheidung für die elektrische Kontaktierung realisiert werden kann.

Die Herstellung von Solarzellen ist mit einer Vielzahl von Prozessschritten zur Präzisionsbearbeitung von Wafern verbunden. Hierzu zählen u.a. die Emitterdiffusion, die Aufbringung einer dielektrischen Schicht sowie deren Mikrostrukturierung, die Dotierung des Wafers, die Rückseitenkontaktierung, die Aufbringung einer Keimschicht sowie deren Verdickung.

Bei der Mikrostrukturierung von dielektrischen Schichten von konventionellen Solarzellen wird meist ein Durchfeuerprozess angewandt, in dem eine lokal aufgebrachte glasfritte-haltige Druckpaste durch einen Temperaturschritt bei etwa 800 bis 900 °C durch die darunter liegende $SiN_x$-Schicht gefeuert wird. Alternativ wird die $SiN_x$-Schicht durch Bestrahlung mit einem Laser lokal ablatiert und der entstehende Kristallschaden nasschemisch anschließend entfernt.

Bei Mikrostrukturierung für Maskierungsprozesse wird üblicherweise ein Vorgehen in mehreren Schritten gewählt, z.B. über Drucken einer resistenten Paste und einem nachfolgenden Nasschemie-Schritt. Weiterhin wird anschließend die Maskierungspaste nasschemisch entfernt. Analog ist eine Mikrostrukturierung durch Photolithografie möglich, d.h. Aufbringung (Sprühen / Schleudern) eines lichtempfindlichen Lackes, Belichtung der gewünschten Struktur durch eine Schattenmaske, Entwickeln und Lösen der belichteten (Positivlack) bzw. unbelichteten (Negativlack) Bereiche, nasschemische oder plasmatechnische Entfernung der dielektrischen Schicht in den geöffneten Bereichen, nasschemische Entfernung des Lackes.

Bei der selektiven Emitter-Dotierung wird ein selektiver Emitter in einem Solarzellenkonzept von BP Solar umgesetzt. Durch Laserbestrahlung werden in die $SiN_x$-beschichtete Vorderseite Gräben eingebracht, der entstandene Laserschaden nasschemisch entfernt und anschließend durch eine $POCl_3$-Diffusion die lokale n-Hochdotierung (selektiver Emitter) durchgeführt.

Den neuesten Stand der Technik stellt hierbei das Konzept des Laser-Doping dar (Ametowobla M., Esturo-Bretön A., Köhler J.R., Werner J.H.: "Laser Processing of Silicon Solar Cells", IEEE (2005)). Hierbei wird auf die Waferoberfläche eine geschlossene Schicht einer phosphorhaltigen Substanz aufgetragen, die dort während eines Temperierschrittes ein Phosphorsilicatglas ausbildet. Durch lokales Erhitzen mit Hilfe eines Laserstrahls wird der Phosphor in das Silicium eingetrieben. Das Phosphorglas muss nach dem Dotierschritt in einem weiteren Teilschritt in der Regel durch Ätzen mit Flusssäuregemischen wieder entfernt werden.

Stand der Technik in der Vorderseiten-Kontaktierung klassischer Solarzellen ist das Bedrucken von $SiN_x$-Schichten mit einer Glasfritte enthaltenden Metallpaste, die in der Regel Silber oder Zinn als Kontaktmetall enthält. Als vorherrschende Drucktechnik dient dabei das Siebdruckverfahren. Nach dem Aufbringen wird die Paste zunächst getrocknet, wobei das organische Lösemittel ausgetrieben wird und dann bei hohen Temperaturen (etwa 900 °C) gefeuert. Im Zuge dieses Sinterschrittes greift die Glasfritte die $SiN_x$-Schicht an, löst sie lokal auf und ermöglicht dadurch die Ausbildung eines Silicium-Metall-Kontaktes. Der Metallkontakt kann zur Reduktion des Leitungswiderstandes anschließend noch galvanisch verdickt werden, bevor daran die Vorderseitenkontakte angelötet werden können.

Nachteilig an diesem Verfahren ist der hohe Kontaktwiderstand, der durch die Glasfritte verursacht wird (> $10^{-3}\Omega$ cm$^2$) und die erforderlichen hohen Prozesstemperaturen, welche die Qualität der Passivierungsschichten, als auch des Siliciumsubstrats reduzieren können.

Eine schonende Möglichkeit, die $SiN_x$-Schicht lokal zu öffnen, besteht in der Anwendung der Photolithographie kombiniert mit nasschemischen Ätzverfahren. Dabei wird zunächst eine Photolackschicht auf den Wafer aufgebracht und über UV-Belichtung und Entwickeln strukturiert. Es folgt ein nasschemischer Ätzschritt in einem flusssäurehaltigen Chemikaliensystem, der das $SiN_x$ an den Stellen entfernt, an denen der Photolack geöffnet wurde. Ein großer Nachteil dieses Verfahrens ist der enorme Aufwand und die damit verbundenen Kosten. Zudem kann mit diesem Verfahren kein für die kommerzielle Solarzellenproduktion ausreichender Durchsatz erreicht werden. Bei einigen Nitriden ist darüber hinaus das hier beschriebene Verfahren nicht anwendbar, da die Ätzraten der verwendeten Ätzsysteme im gegebenen Parameterfenster bei den klassischen nasschemischen Verfahren zu gering sind.

Das Prinzip des schädigungsfreien Abtrags von Siliciumnitrid bei diesem Verfahren beruht darauf, dass der Laserstrahl, bei einer geeigneten Wahl der Laserparameter das Siliciumnitrid so erhitzt, dass es eine Reaktion mit der im Flüssigkeitsstrahl mitgeführten Phosphorsäure eingeht, während die unterhalb der Siliciumnitridschicht liegende, nur einige Nanometer dicke Emitterschicht des Siliciums vom Angriff verschont bleibt.

Auf diese Weise lassen sich Kontaktstellen im Siliciumnitrid wirtschaftlicher als mit den anderen hier beschriebenen Verfahren öffnen. Allerdings bleibt hier nach wie vor das Problem einer Metallkontaktierung mit möglichst geringem Kontaktwiderstand ungelöst. Die Ausbildung eines Metallkontaktes erfolgt bei diesem Ansatz erst in weiteren nachfolgenden Prozessschritten.

Die stromlose Nickelabscheidung wird gegenwärtig der galvanischen Abscheidung von Nickel aufgrund zahlreicher Vorteile bevorzugt, zu denen vor allem folgende Aspekte zu zählen sind (Pearlstein, F: Electroless Plating in: "Modern Electroplating", 3rd Edition, Ed.: Frederick Lowerheim, Wiley (1974), 710-744):

- Es ist eine einheitlichere Abscheidung ohne Bevorzugung topographisch exponierter Bereiche oder Kanten möglich.
- Die stromlos abgeschiedenen Schichten besitzen geringere Porositäten als galvanisch abgeschiedene.
- Es ist keine Stromzufuhr und Kontaktierung erforderlich. Dies bedeutet eine erhebliche technische Vereinfachung gegenüber der galvanischen Abscheidung.
- Es sind auch Abscheidungen direkt auf nicht leitenden Materialien möglich.
- Die deponierten Schichten besitzen einheitliche chemische und mechanische Eigenschaften.

Essenzielle Komponenten von Nickelbädern sind:

1) Ein Nickelsalz, z.B. $NiCl_2$ (x $H_2O$), $NiSO_4$ ·(x $H_2O$), etc.
2) Ein reduzierendes Agens (vorwiegend ein Hy- pophosphit, $H_2PO_2^-$ oder Borane, z.B. $B_2H_6$)
3) Ein oder mehrere Salze organischer Säuren, welche Komplexbildner für Ni-Ionen und gleichzeitig Puf- fer sind. Als Beispiele sind hier zu nennen: ver- schiedene Citrate, Tatrate, Lactate, Acetate, etc.

Der Abscheidungsprozess erfolgt durch katalytische Dehydrogenierung von Hypophosphit verbunden mit einem Transfer an Hydrid-Ionen auf die katalytische Oberfläche und anschließender Reaktion von Hydrid-Ionen mit $Ni^{2+}$-Ionen.

Klassische Nickelbäder zur stromlosen Abscheidung von Nickel besitzen hohe Instabilitäten, die unter anderem häufig dazu führen, dass in der Praxis unerwünscht Nickel ausfällt.

Bei der stromlosen Nickelabscheidung taucht die mit Nickel zu beschichtende Oberfläche des Werkstücks in eine beheizte Nickellösung. Es findet jedoch nur an jenen Stellen eine Abscheidung von Nickel statt, an denen die Oberfläche des Werkstücks katalytisch wirkt. Bei der klassischen stromlosen Nickelabscheidung wird dies dadurch gewährleistet, dass die zu beschichtenden Bereiche mit einer anderen Metallkeimschicht versehen sind, in der Regel mit einem Platinmetall, z.B. Pd oder Pt. Eine kostengünstigere Alternative hierzu ist die Bekeimung mit Zinn.

Neuere Arbeiten haben gezeigt, dass Oberflächen von Halbleitern bei der stromlosen Abscheidung von Nickel auch dann katalytisch wirken können, wenn sie hoch dotiert sind, lokal kristalline Schädigungen aufweisen, die beispielsweise durch Bestrahlung mit Laserlicht oder mechanische Einwirkung hervorgerufen wurden oder eine sehr große effektive Oberfläche besitzen, etwa durch eine stark poröse Beschaffenheit. Auch lokal durch Bestrahlung mit Laserlicht oder andere energiereiche Strahlungen generierte Elektronen/Loch-Paare können katalytisch wirken.

Wang J., Xudong F., Zuzhan Y., Zhao G: "Laser-induced selective deposition of Ni-P alloy on silicon, Applied Surface Science 84 (1995) 383-389", haben auf diese Weise Nickel aus einem klassischen Nickelbad auf porösem p-Typ-Silicium abgeschieden, indem sie die Oberfläche lokal mit einem $Ar^+$-Ionen-Laser der Wellenlänge $\lambda$ = 514,5 nm und Laserleistungen zwischen 65 W/cm$^2$ und 88 W/cm$^2$ über die Dauer von 15 bis 30 min. belichteten.

Aus der US 5,059,449 ist ein Verfahren bekannt, bei dem sowohl Halbleiter, Metalle, wie Isolatoroberflächen stromlos mit einer Metallschicht überzogen werden können unter Umgehung der Verwendung klassischer phosphorhaltiger Reduktionsmittel, wie beispielsweise Hypophosphit. Die Substratoberfläche wird dabei durch eine Metallsalzlösung hindurch mit einem Laser bestrahlt, wobei das Laserlicht lokal eine thermische Zersetzung verschiedener Wasserstoff-Verbindungen in der Lösung hervorruft. Der auf diese Weise gebildete Wasserstoff dient dabei als Reduktionsmittel für das Nickel. Bevorzugte Wasserstoffquellen sind hier Ammoniak und Cyclohexanol.

Die bisher fortschrittlichste Prozessierung von Vorderseitenkontakten bei kommerziellen Siliciumsolarzellen erfolgt bei den so genannten BC ("buried contact")-Solarzellen, wie beispielsweise der SATURN®-Solarzelle der Firma BP Solarex.

Nach einer klassischen Emitterdiffusion mit $POCl_3$ als Phosphorquelle und anschließendem Auftragen einer Antireflexschicht mit PECVD-Verfahren werden hier mit Hilfe eines trockenen Laserstrahls Gräben von maximal 50 μm Tiefe und 20 bis 30 μm Breite durch den Emitter hindurch in den darunter liegenden Silicium-Bulk geschnitten. Das dabei geschädigte Material wird im Rahmen eines darauf folgenden Ätzschrittes aus den Schnittgräben entfernt. Es folgt ein zweiter Diffusionsschritt im Zuge dessen ein hoch dotierter Bereich (n$^{++}$) in den Gräben und auf der Rückseite des Wafers erzeugt wird. Die Antireflexschicht auf der Vorderseite schützt den flächigen Emitter vor weiterem Eintrag an Dotieratomen. Nach dem Diffusionsschritt wird das Phosphorsilicatglas aus den Gräben durch einen Ätzschritt mit flusssäurehaltigen Lösungen entfernt. An den hoch dotierten Wänden der Gräben wird Nickel stromlos in Form einer dünnen, aber geschlossenen Schicht abgeschieden. Galvanisch abgeschiedenes Kupfer in den Gräben dient als Metallkontakt bei der auf diese Weise gefertigten Solarzelle.

BC-Solarzellen haben gegenüber klassischen Solarzellen mit Siebdruckkontakten eine Reihe entscheidender Vorteile (Green M.A., Wenham S.R., Zhao J., Bowden S., Milne A.M., Taouk M., Zhang F.: "Present Status of Buried Contact Solar Cells", IEEE Transactions on Electron Devices, (1991), 46-53):

1)  Durch die Nutzung von Lasern als Mikrostruktu- rierungsinstrument können bei der Kontaktierung wesentlich feinere Strukturen als mit der Sieb- drucktechnik erzielt werden.

2)  Die zur Kontaktierung gewählte, in den Gräben abgeschiedene Metallmischung verfügt über eine höhere Leitfähigkeit als die aus den Silberpas- ten gesinterten Kontakte. Die höhere Leitfähig- keit der Kontakte führt wiederum zu einer Ver- ringerung des Serienwiderstands der Solarzelle.

3)  Obwohl die Kontaktfläche erhöht wird, sinken die durch die Kontakte verursachten Abschattungsver- luste an der Solarzellenoberfläche. Eine gerin- gere Abschattung bedeutet gleichzeitig eine Steigerung des Kurzschlussstromes.

4)  Der hoch dotierte Bereich um die Kontakte herum bildet eine effektive Diffusionsbarriere für die Minoritätsladungsträger und das für Siliciumsolarzellen sehr schädliche, hier jedoch als Kontaktmetall verwendete Kupfer.

Die US 2004/0242019 A1 betrifft ein Verfahren für das Ätzen von Passivierungs- und Antireflexionsschichten aus Siliciumnitrid. Weiterhin ist ein Ätzmedium, dessen Verwendung sowie eine Solarzelle beschrieben.

Die DE 10 2005 032 807 A1 betrifft kombinierte Ätz- und Dotiermedien für Siliciumdioxidschichten und darunter liegendes Silicium. Weiterhin wird ein Verfahren zum Ätzen von Passivierungs- und Antireflexschichten aus Siliciumdioxid auf Solarzellen, ein Ätzmedium, dessen Verwendung sowie eine entsprechend hergestellte Solarzelle beschrieben.

Ausgehend hiervon war es Aufgabe der vorliegenden Erfindung, die prozesstechnische Durchführung der einzelnen Verfahrensschritte zur Präzisionsbearbeitung von Substraten, insbesondere Wafern, zu vereinfachen und gleichzeitig eine höhere Präzision dieser Prozessschritte zu ermöglichen.

Diese Aufgabe wird durch das Verfahren mit den Merkmalen des Anspruchs 1 gelöst. Die weiteren abhängigen Ansprüche zeigen vorteilhafte Weiterbildungen auf.

Erfindungsgemäß wird ein Verfahren zur simultanen Mikrostrukturierung, Dotierung und zumindest bereichsweisen Aufbringung einer Keimschicht_von Substraten bereitgestellt, bei dem ein auf eine Substratoberfläche gerichteter Laserstrahl über die zu bearbeitenden Bereiche des Substrats geführt wird, wobei das Substrat zumindest an den zu bearbeitenden Bereichen des Substrates von einer ein Bearbeitungsreagenz enthaltenden Flüssigkeit bedeckt ist und als Bearbeitungsreagenz ein Ätzmittel, ein Dotierstoff, mindestens eine Metallverbindung und ein Reduktionsmittel in der Flüssigkeit enthalten sind.

Das erfindungsgemäße Verfahren beruht auf dem flüssigkeitsunterstützten Laser und verwendet je nach Anwendung Flüssigkeiten mit unterschiedlichen Bearbeitungsreagenzien bzw. unterschiedliche Laserquellen. aus diesen Möglichkeiten ergeben sich vorteilhaft Prozesssequenzen zur Herstellung von Solarzellen.

Das erfindungsgemäße Verfahren basiert darauf, dass das Substrat mit einer ein Bearbeitungsreagenz enthaltenden Flüssigkeit zumindest bereichsweise bedeckt ist, wobei vorteilhafterweise die Dicke der Flüssigkeitsschicht in diesem Bereich genau kontrolliert und dabei verhindert wird, dass keine Wellen- bzw. Flüssigkeitsbewegungen entstehen. Ein Laserstrahl wird auf diesen Bereich des Substrats gerichtet und unter Berücksichtigung der Reflexion, Brechung und Streuung an der Flüssigkeitsoberfläche auf das Substrat fokussiert. Dadurch können thermo- oder fotochemische Reaktionen an den bestrahlten Stellen initiiert werden, wobei die lokale Erhitzung des Materials zu einer lokalen Konvektionsströmung und daher zu einem guten Austausch von reaktiven Chemikalien sorgt.

Erfindungsgemäß nimmt das Laserlicht dabei verschiedene Aufgaben wahr: Zum einen ist es in der Lage, an der Auftreffstelle auf der Substratoberfläche diese lokal aufzuheizen, optional dabei zu schmelzen und im Extremfall zu verdampfen. Durch die zeitgleiche Präsenz von Chemikalien bei den beheizten Substratoberflächen können chemische Prozesse aktiviert werden, die unter Standardbedingungen nicht ablaufen, weil sie kinetisch gehemmt oder thermodynamisch ungünstig sind. Neben der thermischen Wirkung des Laserlichts ist auch eine photochemische Aktivierung möglich, dahingehend, dass das Laserlicht an der Oberfläche des Substrats beispielsweise Elektronen-Lochpaare generiert, die den Ablauf von Redoxreaktionen in diesem Bereich fördern oder gar erst ermöglichen können.

Die Flüssigkeitsschicht ermöglicht dabei durch starke lokale Konvektionsströmungen einen raschen Flüssigkeitsaustausch sowie eine effektivere Kühlung im Vergleich zu Laserverfahren unter Schutzgasatmosphäre.

Laserstrahl und Flüssigkeitsschicht bilden zusammen ein neues Prozesswerkzeug, das in seiner Kombination prinzipiell den Einzelsystemen, aus denen es besteht, überlegen ist.

Sämtliche chemischen Prozesse, die bei der Mikrostrukturierung, Dotierung oder Metallisierung von Siliciumsolarzellen ablaufen, finden unter erhöhten Temperaturen statt. Das bedeutet im Gegenzug, dass die dazu erforderlichen Chemikalien unter Standardbedingungen nicht oder nur sehr schlecht reagieren.

$SiN_x$, das vorwiegend als Antireflexschicht auf Siliciumsolarzellen eingesetzt wird, kann selbst unter für Flüssigkeiten sehr hohen Temperaturen (über 150 °C) nur mit sehr geringen Ätzraten von nur einigen 100 nm bis wenige $\mu$m pro Stunde geätzt werden. Angreifendes Ätzteilchen ist in der Regel das Proton, das verschiedenen Säuren entstammen kann; allerdings wird aufgrund der zum Ätzprozess erforderlichen, hohen Temperaturen vorwiegend konzentrierte Phosphorsäure eingesetzt, deren Siedepunkt bei ca. 180°C liegt, womit sie unter allen gängigen, kommerziell günstig erhältlichen, technischen Säuren den höchsten Siedepunkt besitzt. Die Ätzreaktion verläuft nach dem Schema:

$$3\ Si_3N_4 + 27\ H_2O + 4\ H_3PO_4 \rightarrow 4\ (NH_4)_3PO_4 + H_2SiO_3$$

Klassische Nickel-Galvanisierbäder arbeiten ab Temperaturen von mindestens 70°C, meistens jedoch - je nach Zusammensetzung - erst ab 90 - 100°C effektiv.

Die Bildung des Phosphorsilicatglases aus Phosphorylchlorid $POCl_3$ oder Phosphorsäure mit anschließender Phosphordiffusion erfolgt bei Temperaturen über 800°C.

Die bei den einzelnen Prozessschritten verwendeten Reagenzien weisen deutliche chemische Parallelen auf: In allen drei Prozessschritten werden phosphorhaltige Substanzen eingesetzt, jedoch mit zum Teil unterschiedlichen Oxidationsstufen des Phosphors. Dieser besitzt in der Phosphorsäure die Oxidationsstufe +V während er im Hypophosphit die Oxidationszahl +I aufweist und dort entsprechend ein starkes Reduktionsmittel ist, während das Hydrogenphosphat-Ion weder eine starke Reduktions- noch Oxidationsneigung zeigt. Die Reduktionsneigung des Hypophosphits ist vom pH-Wert der Lösung abhängig; in basischen Lösungen ist sie höher als im neutralen oder sauren Milieu. Hingegen kommt die Ätzwirkung der Phosphorsäure auf das Siliciumnitrid nur in sauren Lösungen zur Geltung. Bei der Phosphorsilicatglasbildung ist der pH-Wert der verwendeten phosphorhaltigen Substanz weniger von Bedeutung als die Absättigung der Valenzen des Phosphors mit Sauerstoffatomen. Diese werden zur Netzwerkbildung im Phosphorsilicatglas benötigt, wo sie die Bindungsbrücken zwischen den Silicium- und den Phosphoratomen bilden. Entsprechend ist Phosphorsäure ein besserer Glasbildner als beispielsweise phosphorige Säure oder Hypophosphit. Die Verglasung des sauerstoffarmen Phosphorylchlorids erfolgt aus diesem Grund nur in einer Sauerstoff enthaltenden Atmosphäre.

Die Zusammensetzung der einzelnen Reaktionsmedien, die Chemie des Phosphors und seiner Sauerstoffverbindungen sowie die Tatsache, dass bei allen drei Prozessschritten erhöhte bis zum Teil sehr hohe Temperaturen erforderlich sind, ermöglicht eine Zusammenfassung der drei Prozessschritte: Nitridstrukturierung, Phosphordotierung und Metallisierung von Siliciumsolarzellen in einen einzigen Hochtemperaturschritt.

Vorzugsweise wird das Substrat in die das Bearbeitungsreagenz enthaltende Flüssigkeit eingetaucht.

Vorzugsweise ist das Substrat ausgewählt aus der Gruppe bestehend aus Silicium, Glas, Metall, Keramik, Kunststoff und deren Verbundstoffen. Das Substrat kann dabei vorzugsweise an der zu behandelnden Oberfläche auch eine oder mehrere Beschichtungen aufweisen. Hierzu zählen Beschichtungen aus $SiN_x$, $SiO_2$, $SiO_x$, $MgF_2$, $TiO_2$ oder $SiC_x$.

Als verwendbare Lasertypen kommen verschiedene Festkörperlaser, insbesondere die kommerziell häufig eingesetzten Nd:YAG-Laser der Wellenlängen 1064 nm, 532 nm, 355 nm, 266 nm und 213 nm, Diodenlaser mit Wellenlängen < 1000 nm, Argon-Ionen-Laser der Wellenlänge 514 - 458 nm und Excimer-Laser (Wellenlängen: 157-351 nm) in Frage.

Tendenziell steigt die Qualität der Mikrostrukturierung mit sinkender Wellenlänge an, weil dabei zunehmend die durch den Laser induzierte Energie in der Oberflächen-Schicht immer besser an der Oberfläche konzentriert wird, was tendenziell zur Verringerung der Wärmeeinflusszone und damit verbunden zur Verringerung der kristallinen Schädigung im Material, vor allem im phosphordotierten Silicium unterhalb der Passivierungsschicht führt. Als besonders effektiv erwiesen sich in diesem Zusammenhang blaue Laser und Laser im nahen UV-Bereich (z.B. 355 nm) und Laser mit Pulslängen im Femtosekunden- bis Nanosekundenbereich.

Für den Dotierungsschritt sind hingegen Infrarotlaser besser geeignet, weil sie eine größere Eindringtiefe als UV-Laser besitzen und auf diese Weise tiefere Schmelzzonen produzieren können, die eine höhere Dotiertiefe erlauben.

Durch den Einsatz insbesondere kurzwelligen Laserlichts besteht darüber hinaus die Option einer direkten Generation von Elektronen/Loch-Paaren im Silizium, die für den elektrochemischen Prozess bei der Nickelabscheidung genutzt werden können. So können beispielsweise durch Laserlicht generierte freie Elektronen im Silicium zusätzlich zum oben bereits beschriebenen Redoxprozess der Nickel-Ionen mit phosphoriger Säure oder Hypophosphit direkt zur Reduktion von Nickel an der Oberfläche beitragen. Diese Elektronen/Loch-Generation kann durch permanente Beleuchtung der Probe mit definierten Wellenlängen (insbesondere im nahen UV mit $\lambda \leq 355$ nm) während des Strukturierungsprozesses permanent aufrechterhalten werden und den Metallkeimbildungsprozess nachhaltig fördern.

Hierzu kann die Solarzelleneigenschaft ausgenutzt werden, um über den p-n-Übergang die Überschussladungsträger zu trennen und damit die n-leitende Oberfläche negativ aufzuladen.

Eine weitere bevorzugte Variante des erfindungsgemäßen Verfahrens sieht vor, dass der Laserstrahl in zeitlicher und/oder räumlicher Pulsform aktiv eingestellt wird. Hierzu zählt die Flattop-Form, ein M-Profil oder ein Rechteckpuls.

Die erfindungsgemäße simultane Mikrostrukturierung, Dotierung und zumindest bereichsweise Aufbringung einer Keimschicht kann in einer ersten bevorzugten Variante eine Emitterdiffusion eines Dotierstoffs in einem Silicium-Wafer als Substrat umfassen.

Durch die lokale Erhitzung des Substrats durch den Laserstrahl können innerhalb dieses begrenzten Bereiches die für die Diffusion im Substrat notwendigen Temperaturen erzeugt und der Dotierstoff eingetrieben werden. Da die Diffusion bei geringen Temperaturen nur extrem langsam erfolgt, wird somit nur im Bereich der auftreffenden Laserstrahlung eine Dotierung des Substrats erreicht, während in den angrenzenden Bereichen des Substrats keine Veränderung erzeugt wird.

Durch das erfindungsgemäße Verfahren wird eine Kristallschädigung bei lokaler Dotierung vermieden, da durch die Laserstrahlung die Oberflächentemperatur unterhalb des Schmelzpunktes gehalten werden kann. Weiterhin wird eine Temperaturbelastung des gesamten Substrats vermieden.

Hinsichtlich der in der Flüssigkeit enthaltenen Dotierstoffe sind alle aus dem Stand der Technik bekannten Dotierstoffe einsetzbar. Besonders bevorzugt sind hier Dotierstoffe ausgewählt aus der Gruppe bestehend aus Phosphor, Bor, Indium, Gallium und Mischungen hiervon.

Eine weitere bevorzugte Variante sieht vor, dass vor oder nach einem der Schritte zur Präzisionsbearbeitung des Substrates eine dielektrische Schicht auf dem Substrat abgeschieden wird. Diese Schicht dient der Passivierung des Substrats.

Die dielektrische Schicht ist dabei vorzugsweise ausgewählt aus der Gruppe bestehend aus $SiN_x$, $SiO_2$, $SiO_x$, $MgF_2$, $TiO_2$ und $SiC_x$.

Eine weitere bevorzugte Variante des erfindungsgemäßen Verfahrens sieht vor, dass bei der Präzisionsbearbeitung eine Mikrostrukturierung der zuvor beschriebenen dielektrischen Schicht erfolgt.

Die Mikrostrukturierung beruht auf einer Öffnung der dielektrischen Schicht, die vorzugsweise durch Behandlung mit einem trockenen Laser geöffnet wird.

Es ist dabei bevorzugt, dass die dielektrische Schicht durch Behandlung mit dem Laser geöffnet wird und das Substrat von einer ein Bearbeitungsreagenz enthaltenden Flüssigkeit bedeckt ist, wobei das Bearbeitungsreagenz ein Ätzmittel ist, das auf die dielektrische Schicht eine stärker ätzende Wirkung als auf das Substrat besitzt. Als Bearbeitungsreagenz wird dabei bevorzugt ein Ätzmittel ausgewählt, mit dem auch Schäden im Substrat nachgeätzt werden können. Bevorzugte Ätzmittel sind ausgewählt aus der Gruppe bestehend aus $H_3PO_4$, KOH, $HF/HNO_3$, Chlorverbindungen und Schwefelsäure.

Die Flüssigkeit kann besonders bevorzugt aus reiner oder hoch konzentrierter Phosphorsäure oder auch verdünnter Phosphorsäure bestehen. Die Phosphorsäure kann z.B. in Wasser oder einem anderen geeigneten Lösungsmittel verdünnt und in unterschiedlicher Konzentration verwendet werden. Auch können Zusätze zur Veränderung von pH-Wert (Säuren oder Laugen), Benetzungsverhalten (z.B. Tenside) oder Viskosität (z.B. Alkohole) zugesetzt werden. Besonders gute Ergebnisse werden bei Verwendung einer Flüssigkeit erzielt, die Phosphorsäure mit einem Anteil von 50 bis 85 Gew.-% enthält. Damit lässt sich insbesondere eine zügige Bearbeitung der Oberflächenschicht ohne Beschädigung des Substrats und umliegender Bereiche realisieren.

Durch die erfindungsgemäße Mikrostrukturierung wird mit sehr geringem Aufwand zweierlei erreicht.

Einerseits kann die Oberflächenschicht in den genannten Bereichen vollständig abgetragen werden, ohne dass das Substrat dabei beschädigt wird, weil die Flüssigkeit auf letzteres eine weniger (vorzugsweise gar keine) ätzende Wirkung hat. Zugleich wird durch das lokale Aufheizen der Oberflächenschicht in den abzutragenden Bereichen, wodurch vorzugsweise ausschließlich diese Bereiche aufgeheizt werden, ein gut lokalisiertes, auf diese Bereiche beschränktes Abtragen der Oberflächenschicht ermöglicht. Das ergibt sich aus der Tatsache, dass die ätzende Wirkung der Flüssigkeit typischerweise mit zunehmender Temperatur zunimmt, so dass eine Beschädigung der Oberflächenschicht in benachbarten, nicht aufgeheizten Bereichen durch evtl. dorthin gelangende Teile der ätzenden Flüssigkeit weitgehend vermieden wird.

Um eine möglichst vorteilhafte Metallkontaktierung mit möglichst geringem Kontaktwiderstand zu realisieren, weist in der vorliegenden Erfindung bei der Mikrostrukturierung die Flüssigkeit zusätzlich zum Ätzmittel ein Reduktionsmittel und optional desweiteren ein Metallsalz auf. Vorteilhafterweise weisen dabei das Ätzmittel und das Reduktionsmittel ein und dasselbe chemische Element, z.B. Phosphor in unterschiedlichen Oxidationsstufen auf. In besonders vorteilhaften Ausführungsformen werden somit die folgenden Paare im Komponentensystem eingesetzt: Als Ätzmittel $H_3PO_4$ und als Reduktionsmittel $H_3PO_3$; als Ätzmittel $H_2SO_4$ und als Reduktionsmittel $H_2SO_3$; als Ätzmittel $HNO_3$ und als Reduktionsmittel $HNO_2$. Vorteilhafterweise sorgen Zusätze von KF für eine definierte Menge freier Flusssäure, welche die Ätzrate auf das SiN noch steigert. Als Metallsalz lassen sich besonders vorteilhaft Salze des Silbers, des Nickels, des Zinns, des Pb, des Aluminiums oder des Chroms einsetzen. Mit Hilfe des Reduktionsmittels ist eine hinsichtlich der Dotierstoffkonzentration höhere Dotierung der Emitterschicht bzw. Substratschicht möglich, was eine spätere, beispielsweise galvanische, Metallabscheidung verbessert und den Kontaktwiderstand reduziert. Bei Zusetzung eines Metallsalzes ist mit Hilfe des Reduktionsmittels an den erwärmten lokalen Oberflächenbereichen eine Reduktion der Metallionen zu elementarem Metall möglich, was zur Ausbildung von effektiven Abscheidekeimen für einen späteren Galvanisierungsprozess führt. Eine solche Deposition von Metallpartikeln führt somit ebenfalls dazu, dass ein Metallkontakt mit geringem Kontaktwiderstand ausgebildet werden kann.

Durch die solchermaßen verbesserten Metall-Kontaktierungen wird die Leitungsfähigkeit von auf diese Weise hergestellten Solarzellen verbessert, ohne dass sich ein erhöhter Bearbeitungsaufwand ergibt.

Bei typischen Anwendungen der erfindungsgemäßen Mikrostrukturierung wird die Oberflächenschicht eine Dicke von zwischen 1 nm und 300 nm haben. Das Substrat kann bei typischen Anwendungen des Verfahrens eine Schichtdicke von zwischen 25 $\mu$m und 800 $\mu$m haben. Damit ergäbe sich ein z.B. zur Herstellung von Solarzellen geeigneter Aufbau.

Gegenüber den aus dem Stand der Technik bekannten Mikrostrukturierungsprozessen können folgende Aspekte der vorliegenden Erfindung als vorteilhafte Weiterentwicklungen angesehen werden:

1) Das flüssigkeitsunterstützte Laserverfahren ist maskenlos, d.h. es wird kein Aufbringen und Entfernen eine Maskierungsschicht benötigt.

2) Der Abtrag von Beschichtungen bzw. Substratma- terial erfolgt schädigungsfrei, d.h. es ist kein anschließendes Reinigen bzw. Nachätzen notwendig.

Erfindungsgemäß werden die Mikrostrukturierung und Dotierung simultan durchgeführt.

Ebenso umfasst das erfindungsgemäße Verfahren als weitere Variante, dass nur bereichsweise eine Dotierung im Substrat erzeugt wird, anschließend auf der Substratoberfläche befindliche Flüssigkeit eingetrocknet und das Substrat thermisch behandelt wird, so dass das Substrat eine schwache Flächendotierung und eine eingetriebene hohe Lokaldotierung aufweist. Der verwendete Dotierstoff ist vorzugsweise ausgewählt aus der Gruppe bestehend aus Phosphorsäure, Phosphorige Säure, Borverbindungen, Galliumverbindungen und Mischungen hiervon.

Gegenüber den aus dem Stand der Technik bekannten Dotierprozessen können folgende Aspekte der vorliegenden Erfindung als vorteilhafte Weiterentwicklungen angesehen werden:

3) Beim Dotieren mit dem neuen Verfahren ist kein weiterer Temperierschritt zwingend erforder- lich.

4) Es werden mit relativ geringem technischem Auf- wand im Vergleich zu bisherigen Verfahren sehr hohe Dotierkonzentrationen (ca. $10^{21}$ P-Atome/ cm$^3$) und damit verbunden geringe Kontaktwider- stände erreicht.

Nach einer weiteren Variante des erfindungsgemäßen Verfahrens umfasst die simultane Mikrostrukturierung, Dotierung und zumindest bereichsweise Aufbringung einer Keimschicht eine zumindest bereichsweise Aufbringung einer Keimschicht auf einem Silicium-Wafer. Hierbei handelt es sich somit um einen Metallisierungsschritt.

Bevorzugt ist es dabei, dass im Anschluss an die Dotierung eine Metallisierung der dotierten Oberflächenbereiche durch Austausch der den Dotierstoff enthaltenden Flüssigkeit durch eine mindestens eine Metall-Verbindung enthaltende Flüssigkeit durchgeführt. Auch hier ist es wieder besonders einfach, durch Wechsel der entsprechenden Flüssigkeiten die Verfahrensschritte der Dotierung und Metallisierung sequentiell in der gleichen Vorrichtung durchzuführen.

Die Aufbringung kann dabei durch Nickel-Galvanisierung, Nickel-Laser-Verfahren, Inkjet-Verfahren, Aerosol-Verfahren, Aufdampfen, Lasermikrosintern, Siebdruck und/oder Tampondruck erfolgen. Besonders bevorzugt ist es hierbei, dass die Aufbringung der Keimschicht mit flüssigkeitsunterstützendem Laser durchgeführt wird, wobei das Bearbeitungsreagenz mindestens eine Metallverbindung enthält.

Vorzugsweise wird bei der Metallisierung als Metall-Verbindung eine Verbindung aus der Gruppe der Metalle bestehend aus Silber, Aluminium, Nickel, Titan, Molybdän, Wolfram und Chrom eingesetzt. Besonders bevorzugt wird als Metall-Verbindung Silbercyanid, Silberacetat, Silbernitrat und dessen Lösungen verwendet.

Wird bei der Aufbringung der Keimschicht ein Laserstrahl eingesetzt, so kann dieser die Metallisierung in dem mit Flüssigkeit bedeckten Bereich des Substrats auf der Oberfläche katalysieren. Die Metallisierung kann dabei so lange fortgeführt werden, bis die gewünschte Gesamtstärke erreicht ist oder aber nach dem Aufwachsen einer wenige Nanometer dünnen Schicht gestoppt und im Anschluss galvanisch verdickt werden.

Die zuletzt beschriebene Variante ermöglicht ein Gesamtverfahren, bei dem z.B. ein Silicium-Wafer in einer einzigen Bearbeitungsstation nur unter Austausch der eingesetzten Flüssigkeiten strukturiert, dotiert und metallisiert werden kann.

Vorzugsweise wird die Keimschicht auf den dotierten Bereichen des Silicium-Wafers aufgebracht.

Gegenüber den aus dem Stand der Technik bekannten Metallisierungsverfahren können vor allem folgende Aspekte als vorteilhafte Weiterentwicklungen bisheriger Prozesse betrachtet werden:

1) Mit dem neuen Verfahren können sowohl Öffnung der Nitridschichten, Dotierung und Bekeimung oder Beschichtung der hoch dotierten Bereiche gleichzeitig in einem einzigen Prozessschritt vollzogen werden. Vor allem die gleichzeitig zur Strukturierung des Nitrids ablaufende Do- tierung mit ein und derselben apparativen Vor- richtung stellt eine vorteilhafte Weiterent- wicklung gegenüber dem bisherigen BC- Solarzellen-Kontaktierungsprozess dar.

2) Durch geschickte Wahl der Do- tier/Metallisierlösung kann sogar eine dem Do- tieren/Metallisieren parallel verlaufende Scha- densätze der gefertigten Gräben vorgenommen werden.

3) Durch den speziellen Mechanismus bei der Kon- taktierung können die Kontaktqualitäten verbes- sert werden, die sich zum einen in einer besse- ren Haftung äußern, zum anderen in einer Verrin- gerung des Kontaktwiderstands, bedingt durch Ni- ckelsilicid-Bildung an den Kontaktflächen, wo- durch ein weiterer Sintervorgang auch an dieser Stelle des Prozesses nicht mehr zwingend erfor- derlich ist.

4) Ebenso erspart die verwendete Apparatur ein zu- sätzliches Aufheizen der Dotier-/Metallisier- lösungen.

In einer weiteren bevorzugten Variante des erfindungsgemäßen Verfahrens wird nach der Aufbringung der Keimschicht eine Rückseitenkontaktierung aufgebracht. Dies kann besonders bevorzugt durch Aufdampfen oder Sputtern erfolgen. Ebenso ist es möglich, dass nach der Aufbringung der Keimschicht eine zusätzliche Rückseitenkontaktierung durch lasergefeuerte Rückseitenkontaktierung (LFC) aufgebracht wird.

Eine weitere bevorzugte Variante sieht vor, dass nach der Aufbringung der Keimschicht eine thermische Behandlung, insbesondere bei Temperaturen von 100°C bis 900°C, erfolgt. Diese thermische Behandlung kann z.B. durch Laser-Annealing mit Punkt- oder Linienfokus erfolgen.

In einer weiteren Variante des erfindungsgemäßen Verfahrens kann im Anschluss an das Aufbringen der Keimschicht eine Verdickung der Keimschicht erfolgen. Diese Verdickung erfolgt vorzugsweise durch galvanische Abscheidung, z.B. von Ag, oder durch stromlose Abscheidung, z.B. von Cu.

Besonders bevorzugt ist es, einen Gesamtprozess zur Herstellung von Solarzellen bereitzustellen, bei dem mehrere oder alle der zuvor genannten Verfahrensschritte parallel durchgeführt werden. Somit ist ein Gesamtprozess möglich, bei dem eine Mikrostrukturierung, eine Dotierung, die Aufbringung einer Keimschicht und die Verdickung der Keimschicht erfolgen.

Das erfindungsgemäße Verfahren eignet sich insbesondere für verschiedene Verfahrensschritte in der Prozesskette zur Herstellung von Solarzellen. Hierzu gehört die Mikrostrukturierung von Substraten, deren Dotierung und die Aufbringung von Keimschichten auf Silicium-Wafern.

Folgende 6 Prozess-Sequenzen (A-F) werden durch das erfindungsgemäße Verfahren möglich. Im Folgenden wird die Abkürzung LAL (Liquid-Assisted Laser) als Oberbegriff für alle flüssigkeitsunterstützte Laserverfahren mit reaktiven Trägerflüssigkeiten verwendet.

Die Prozess-Sequenzen starten mit gereinigten Wafern, die vom Sägeschaden befreit und ggf. texturiert wurden. Einzelschritte, die für die Gesamtsequenz nicht zwingend benötigt werden, sind mit "(optional)" gekennzeichnet.

**A: Emitterdiffusion, Passivierung, Passivierung laseröffnen, Keimschicht aufwachsen und verdicken**

- Diffusion selektiver Emitter (Schichtwiderstand <30 Ω/sq), z.B. über Maskier-Oxidation, Strukturierung über Photolithografie, $POCl_3$-Diffusion im Rohrofen, Ätzen Phosphorsilicatglas in Flusssäure (optional).

- Diffusion flacher Emitter (Schichtwiderstand 40-300 Ω/sq), z.B. über $POCl_3$-Diffusion im Rohrofen, Ätzen Phosphorsilicatglas in Flusssäure. Alternativ kann ein Emitter aufepitaxiert werden.

- Entfernung parasitärer Emitter: Über Inline-Nasschemie, z.B. einseitiges Ätzen in $HF/HNO_3$-Mischungen (optional).

- Abscheidung einer oder mehrerer dielektrischer Schichten auf Vorderseite und/oder Rückseite:

    Z.B. über Aufdampfen, PECVD-Verfahren oder Sputtern. Schichtmaterialien z.B. $SiN_x$, $SiO_2$, $SiO_x$, $MgF_2$, $TiO_2$, $SiC_x$.

- Lokale Mikrostrukturierung/Öffnung dielektrische Schicht: Über konventionelle Laser, wasserstrahlgeführte Laser, LAL (Ätzmittel angepasst auf Ätzwirkung bzgl. dielektrische Schicht oder bzgl. Silicium) oder Aerosoljetten von Phosphorsäure.

- Tempern bei 100-900°C für 0.5-30 min, z.B. im Rohrofen, Durchlaufofen oder über Laser-Annealing mit konventionellen Lasern mit Punkt- oder Linienfokus (optional).

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional).

- Konditionieren der Oberfläche zum Entfernen von störenden Oberflächenschichten, z.B. nativem $SiO_2$ über kurzen nasschemischen Schritt, z.B. HF-Dip (optional).

- Aufbringung der Keimschicht: Durch stromlose Ni-Abscheidung im Dunkeln oder unter konventioneller Beleuchtung, LAL mit metallhaltiger Flüssigkeit, Inkjetting, Aerosolsprühen, Aufdampfen, Lasersintern von Metallpulvern, Sieb- oder Tampondruck von frittelosen Metallpasten.

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional, falls vorher noch nicht aufgebracht).

- Tempern bei 100-900°C für 0.5-30 min, z.B. im Rohrofen, Durchlaufofen oder über Laser-Annealing mit konventionellen Lasern mit Punkt- oder Linienfokus (optional).

- Kontakt-Verdicken: Über Galvanik, z.B. Ag-Galvanik in cyanidischen Bädern oder stromlose Metallabscheidung (z.B. Cu).

**B: Emitterdiffusion, lokal Keimschicht aufwachsen und verdicken, passivieren**

- Diffusion selektiver Emitter (Schichtwiderstand <30 Ω/sq), z.B. über Maskier-Oxidation, Strukturierung über Photolithografie, $POCl_3$-Diffusion im Rohrofen, Ätzen Phosphorsilicatglas in Flusssäure (optional).

- Diffusion flacher Emitter (Schichtwiderstand 40-300 Ω/sq), z.B. über $POCl_3$-Diffusion im Rohrofen, Ätzen Phosphorsilicatglas in Flusssäure. Alternativ kann ein Emitter aufepitaxiert werden.

- Entfernung parasitärer Emitter: Über Inline-Nasschemie, z.B. einseitiges Ätzen in $HF/HNO_3$-Mischungen (optional).

- Tempern bei 100-900°C für 0.5-30 min, z.B. im Rohrofen, Durchlaufofen oder über Laser-Annealing mit konventionellen Lasern mit Punkt- oder Linienfokus (optional).

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional).

- Konditionieren der Oberfläche zum Entfernen von störenden Oberflächenschichten, z.B. nativem $SiO_2$ über kurzen nasschemischen Schritt, z.B. HF-Dip (optional).

- Aufbringung der Keimschicht: Durch stromlose Ni-Abscheidung unter lokaler konventioneller Beleuchtung, LAL mit metallhaltiger Flüssigkeit, Inkjetting, Aerosolsprühen, Aufdampfen, Lasersintern von Metallpulvern, Sieb- oder Tampondruck von frittelosen Metallpasten.

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional, falls vorher noch nicht aufgebracht).

- Tempern bei 100-900°C für 0.5-30 min, z.B. im Rohrofen, Durchlaufofen oder über Laser-Annealing mit konventionellen Lasern mit Punkt- oder Linienfokus (optional).

- Kontakt-Verdicken: Über Galvanik, z.B. Ag-Galvanik in cyanidischen Bädern oder stromlose Metallabscheidung (z.B. Cu).

- Abscheidung einer oder mehrerer dielektrischer Schichten auf Vorderseite und/oder Rückseite:

    Z.B. über Aufdampfen, PECVD-Verfahren oder Sputtern. Schichtmaterialien z.B. $SiN_x$, $SiO_2$, $SiO_x$, $MgF_2$, $TiO_2$, $SiC_x$.

**C: Emitterdiffusion, Passivierung, Passivierung öffnen und lokal dotieren mit LAL, Keimschicht aufwachsen und verdicken**

- Diffusion flacher Emitter (Schichtwiderstand 40-300 $\Omega$/sq), z.B. über POCl$_3$-Diffusion im Rohrofen, Ätzen Phosphorsilicatglas in Flusssäure. Alternativ kann ein Emitter aufepitaxiert werden.

- Entfernung parasitärer Emitter: Über Inline-Nasschemie, z.B. einseitiges Ätzen in HF/HNO$_3$-Mischungen (optional).

- Abscheidung einer oder mehrerer dielektrischer Schichten auf Vorderseite und/oder Rückseite:

    Z.B. über Aufdampfen, PECVD-Verfahren oder Sputtern. Schichtmaterialien z.B. SiN$_x$, SiO$_2$, SiO$_x$, MgF$_2$, TiO$_2$, SiC$_x$.

- Lokale Mikrostrukturierung/Öffnung dielektrische Schicht mit gleichzeitiger lokaler Hochdotierung über LAL (Ätzmittel angepasst auf Ätzwirkung bzgl. dielektrische Schicht oder bzgl. Silicium).

- Tempern bei 100-900°C für 0.5-30 min, z.B. im Rohrofen, Durchlaufofen oder über Laser-Annealing mit konventionellen Lasern mit Punkt- oder Linienfokus (optional).

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional).

- Konditionieren der Oberfläche zum Entfernen von störenden Oberflächenschichten, z.B. nativem SiO$_2$ über kurzen nasschemischen Schritt, z.B. HF-Dip (optional).

- Aufbringung der Keimschicht: Durch stromlose Ni-Abscheidung im Dunkeln oder unter konventioneller Beleuchtung, LAL mit metallhaltiger Flüssigkeit, Inkjetting, Aerosolsprühen, Aufdampfen, Lasersintern von Metallpulvern, Sieb- oder Tampondruck von frittelosen Metallpasten.

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional, falls vorher noch nicht aufgebracht).

- Tempern bei 100-900°C für 0.5-30 min, z.B. im Rohrofen, Durchlaufofen oder über Laser-Annealing mit konventionellen Lasern mit Punkt- oder Linienfokus (optional).

- Kontakt-Verdicken: Über Galvanik, z.B. Ag-Galvanik in cyanidischen Bädern oder stromlose Metallabscheidung (z.B. Cu).

**D: LAL flacher und tiefer Emitter gleichzeitig, Keimschicht aufwachsen und verdicken**

- Lokale Hochdotierung über LAL (Ätzmittel angepasst auf Ätzwirkung bzgl. dielektrische Schicht oder bzgl. Silicium), danach Trocknung der den Wafer benetzenden Flüssigkeit als Dotierstoff für eine nachfolgende flächige, schwache Dotierung.

- Tempern bei 100-900°C für 0.5-30 min, z.B. im Rohrofen, Durchlaufofen oder über Laser-Annealing mit konventionellen Lasern mit Punkt- oder Linienfokus zum Diffundieren des flachen Emitters.

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional).

- Konditionieren der Oberfläche zum Entfernen von störenden Oberflächenschichten, z.B. nativem SiO$_2$ über kurzen nasschemischen Schritt, z.B. HF-Dip (optional).

- Aufbringung der Keimschicht: Durch stromlose Ni-Abscheidung unter lokaler konventioneller Beleuchtung, LAL mit metallhaltiger Flüssigkeit, Inkjetting, Aerosolsprühen, Aufdampfen, Lasersintern von Metallpulvern, Sieb- oder Tampondruck von frittelosen Metallpasten.

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional, falls vorher noch nicht aufgebracht).

- Tempern bei 100-900°C für 0.5-30 min, z.B. im Rohrofen, Durchlaufofen oder über Laser-Annealing mit konventionellen Lasern mit Punkt- oder Linienfokus (optional).

- Kontakt-Verdicken: Über Galvanik, z.B. Ag-Galvanik in cyanidischen Bädern oder stromlose Metallabscheidung (z.B. Cu).

- Abscheidung einer oder mehrerer dielektrischer Schichten auf Vorderseite und/oder Rückseite:

  Z.B. über Aufdampfen, PECVD-Verfahren oder Sputtern. Schichtmaterialien z.B. $SiN_x$, $SiO_2$, $SiO_x$, $MgF_2$, $TiO_2$, $SiC_x$.

**E: Emitterdiffusion, Passivierung, LAL Öffnen + Dotierung + Keimschicht Abscheidung gleichzeitig, Verdickung**

- Diffusion flacher Emitter (Schichtwiderstand 40-300 $\Omega$/sq), z.B. über $POCl_3$-Diffusion im Rohrofen, Ätzen Phosphorsilicatglas in Flusssäure. Alternativ kann ein Emitter aufepitaxiert werden.

- Entfernung parasitärer Emitter: Über Inline-Nasschemie, z.B. einseitiges Ätzen in $HF/HNO_3$- Mischungen (optional).

- Abscheidung einer oder mehrerer dielektrischer Schichten auf Vorderseite und/oder Rückseite:

  Z.B. über Aufdampfen, PECVD-Verfahren oder Sputtern. Schichtmaterialien z.B. $SiN_x$, $SiO_2$, $SiO_x$, $M9F_2$, $TiO_2$, $SiC_x$.

- Öffnung dielektrische Schicht, lokale Hochdotierung sowie Abscheidung Keimschicht über LAL.

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional).

- Tempern bei 100-900°C für 0.5-30 min, z.B. im Rohrofen, Durchlaufofen oder über Laser-Annealing mit konventionellen Lasern mit Punkt- oder Linienfokus (optional).

- Kontakt-Verdicken: Über Galvanik, z.B. Ag-Galvanik in cyanidischen Bädern oder stromlose Metallabscheidung (z.B. Cu).

**F: Emitterdiffusion, Passivierung, LAL Öffnen + Dotierung + Keimschicht Abscheidung gleichzeitig, Keimschicht komplettieren, Verdickung**

- Diffusion flacher Emitter (Schichtwiderstand 40-300 $\Omega$/sq), z.B. über $POCl_3$-Diffusion im Rohrofen, Ätzen Phosphorsilicatglas in Flusssäure. Alternativ kann ein Emitter aufepitaxiert werden.

- Entfernung parasitärer Emitter: Über Inline-Nasschemie, z.B. einseitiges Ätzen in $HF/HNO_3$-Mischungen (optional).

- Abscheidung einer oder mehrerer dielektrischer Schichten auf Vorderseite und/oder Rückseite:

  Z.B. über Aufdampfen, PECVD-Verfahren oder Sputtern. Schichtmaterialien z.B. $SiN_x$, $SiO_2$, $SiO_x$, $MgF_2$, $TiO_2$, $SiC_x$.

- Öffnung dielektrische Schicht, lokale Hochdotierung sowie Abscheidung Keimschicht über LAL.

- Komplettierung der Keimschicht: Durch stromlose Ni-Abscheidung unter lokaler konventioneller Beleuchtung, LAL mit metallhaltiger Flüssigkeit, Inkjetting, Aerosolsprühen, Aufdampfen, Lasersintern von Metallpulvern, Sieb- oder Tampondruck von frittelosen Metallpasten. Dieser Schritt dient zur Komplettierung der u.U. nicht durchgängigen Keimschicht, die im vorangegangenen Schritt aufgebracht wurde. Durch den 2-stufigen Prozess kann die Haftung auf dem Substrat erhöht werden, da der LAL-Prozess die Metallatome in das flüssige Silicium einbringt.

- Aufbringung des Rückseitenkontaktes, z.B. über Siebdruck metallhaltiger Pasten und Feuern oder Aufdampfen von Metall-Schichtsystemen und LFC-Prozess (Laser Fired Contacts) (optional).

- Tempern bei 100-900°C für 0.5-30 min, z.B. im Rohrofen, Durchlaufofen oder über Laser-Annealing mit konventionellen Lasern mit Punkt- oder Linienfokus (optional).

- Kontakt-Verdicken: Über Galvanik, z.B. Ag-Galvanik in cyanidischen Bädern oder stromlose Metallabscheidung (z.B. Cu).

Anhand der nachfolgenden Beispiele soll der erfindungsgemäße Gegenstand näher erläutert werden, ohne diesen auf die hier gezeigten speziellen Ausführungsformen einschränken zu wollen. Alle in diesen Beispielen beschriebenen Gesamtprozesse können auch durch eine vereinfachte Flüssigkeitszusammensetzung auf ihre Teilprozesse reduziert werden. So kann beispielsweise eine Siliciumnitrid-Strukturierung mit gleichzeitiger Dotierung auch ohne Metallisierung erfolgen, wenn das Metallsalz der Lösung nicht zugesetzt wird.

**Beispiel 1**

**Nitridstrukturierung/Dotierung und Bekeimung mit einer Lösung aus Hypophosphit, Phosphorsäure und einem Metallsalz**

In einer Ausführung der vorliegenden Erfindung werden alle drei Chemikaliensysteme aus den drei Einzelschritten vereint und deren Konzentrationen dem neuen System angepasst. Dem Konzept entgegen kommt die Tatsache, dass die Wechselwirkungen der nicht Phosphor enthaltenden Reagenzien aus den einzelnen Prozessschritten untereinander gering sind. So z. B. behindern Metall-Ionen keineswegs die Phosphorglasbildung und auch nicht die Ätzwirkung der Phosphorsäure auf das Siliciumnitrid. Hydrogenphosphate und Hypophosphit-Ionen bilden zusammen ein effektives Redoxpaar, das Metall-Ionen zu reduzieren in der Lage ist. Der niedrige pH-Wert der Lösung und die Anwesenheit der Hydrogenphosphat-Ionen verringert das Reduktionspotential des Hypophosphits, was zunächst einmal nicht unerwünscht ist, weil dadurch die Gefahr einer spontanen Zersetzung des Reaktionsbades, wie sie bei Bädern zur stromlosen Abscheidung von Nickel gegeben ist, deutlich reduziert wird.

Allerdings handelt es sich bei der hypophosphorigen Säure nur um eine sehr schwache Säure mit einem sehr niedrigen Siedepunkt. Die geringe Säurestärke der hypophosphorigen Säure sorgt allerdings dafür, dass die Protonenkonzentration nunmehr fast ausschließlich durch die Phosphorsäurekonzentration in der Lösung bestimmt wird, die ihrerseits nicht zu hoch ausfallen darf, weil damit das Reduktionspotential des Hypophosphits zu sehr absinkt, um noch Metall-Ionen reduzieren zu können. Der Konzentrationsspielraum der einzelnen Komponenten ist demnach in solch einem System nicht unbegrenzt. Der niedrige Siedepunkt der hypophosphorigen Säure erschwert darüber hinaus ihre Handhabbarkeit und erhöht die Gefahr einer allmählichen Konzentrationsverringerung im System durch Verflüchtigung dieser für das Gesamtsystem wichtigen Komponente. Sehr hohe Konzentrationen an Hypophosphit in Lösung verringern die Haltbarkeit des flüssigen Mediums, was für den technischen Einsatz ein erhebliches Problem darstellt. Das Chemikaliensystem erweist sich mit Hypophosphit als Reduktionsmittel demnach als äußerst labil, jedoch durchaus sehr effektiv, wenn keine lange Haltbarkeit der Lösung erforderlich ist.

Im vorgestellten Beispiel können unter anderem die folgenden Komponentensysteme zum Einsatz kommen:

$[NiCl_2 \cdot 6\ H_2O]$ - 0,1-1 mol/L

$[NaH_2PO_2 \cdot H_2O]$ = 0,1- 5 mol/L

$[H_3PO_4]$ = 0,5 - 5 mol/L

Komplexbildner für $Ni^{2+}$-Ionen und Puffer, z.B.: Hydroxyessigsäure mit: $[HOCH_2COOH]$ = 0,5 - 2 mol/L

**Beispiel 2**

**Nitridstrukturierung/Dotierung und Bekeimung mit einer Lösung aus phosphoriger Säure, Phosphorsäure und einem Metallsalz**

Stabiler gegen spontane Zersetzung sind Systeme aus Phosphorsäure und phosphoriger Säure mit wasserlöslichen Nickelsalzen als Metallquellen, z. B.: Nickelchloriden $NiCl_2 \cdot x\ H_2O$, Nickelsulfaten $NiSO_4 \cdot x\ H_2O$ oder Nickelnitraten $Ni(NO_3)_2 \cdot x\ H_2O$. Der pH-Wert solcher Systeme wird mit Hilfe von Kaliumhydroxid-Lösung oder besser noch Ammoniumhydroxid-Lösung eingestellt. Er liegt in der Regel im leicht sauren Bereich. $HPO_3^{2-}$ -Ionen aus der phosphorigen Säure und $HPO_4^{2-}$ - Ionen aus der Phosphorsäure bilden zusammen ein Redoxpaar. Das zweite Redoxpaar wird durch das Nickel in der Form $Ni^{2+}/Ni^{0}$ gebildet:

$HPO_3^{2-} + 3\ OH^- \rightleftarrows HPO_4^{2-} + 2\ H_2O + 2\ e$  E° = - 1, 12 V

$Ni \rightleftarrows Ni^{2+} + 2\ e^-$  E° = 0,25 V

In basischen Medien ist das $HPO_3^{2-}$ -Ion genau wie das Hypophosphit ein starkes Reduktionsmittel, d.h. es ist dann auch in der Lage, Ionen einiger unedlerer Metalle zum elementaren Metall zu reduzieren, was jedoch nicht so spontan wie beim Hypophosophit erfolgt, aufgrund des geringeren Reduktionspotentials des Phosphit-Ions, in dem der Phosphor die Oxidationsstufe +III aufweist, gegenüber dem Hypophosphit, wo sie +I beträgt. Eine spontane Reduktion von $Ni^{2+}$-Ionen mit phosphoriger Säure wird in wässrigen Lösungen kaum beobachtet. An heißen, katalytisch wirkenden Oberflächen ist eine Oxidation des Phosphit-Ions zu Phosphat unter Reduktion von Metall-Ionen, auch denen des Nickels, hingegen ohne weiters möglich.

Phosphorige Säure hat gegenüber hypophosphoriger Säure darüber hinaus zwei weitere wesentliche Vorteile:

1) Sie besitzt einen deutlich höheren Siedepunkt als die hypophosphorige Säure und verflüchtigt sich daher weit weniger schnell.

2) Sie ist eine wesentlich stärkere Säure und so- mit ähnlich der Phosphorsäure ein effektiveres Ätzmedium für das Siliciumnitrid als die hypophosphorige Säure.

Thermodynamische Förderung des Redoxprozesses zur Metallabscheidung:

Das Reduktionsvermögen (die elektromotorische Kraft des $HPO_3^{2-}$ / $HPO_4^{2-}$ -Systems) einer $HPO_3^{2-}$ -Ionen enthaltenden Lösung ist abhängig von den Aktivitäten der besagten Ionen in der Lösung und vom pH-Wert der Lösung, genauer gesagt, der Hydroxid-Ionen-Konzentration. Dies wird aus der Nernstschen Gleichung für das System $HPO_3^{2-}$ / $HPO_4^{3-}$ ersichtlich:

$$\Delta E(HPO_3^{2-} / HPO_4^{2-}) = -1{,}12V + \frac{0{,}059}{2} \cdot \log \frac{a(HPO_4^{2-})}{a(HPO_3^{2-}) \cdot a(OH^-)^3} V$$

In verdünnten Lösungen ist die Aktivität a der einzelnen Spezies gleichzusetzen mit deren Konzentration c der jeweiligen Spezies in der Lösung. Je höher die $HPO_3^{2-}$-Ionen-Konzentration und/oder je höher der pH-Wert, desto negativer wird $\Delta E(HPO_3^{2-} / HPO_4^{2-})$, also desto mehr steigt das Reduktionsvermögen der Halbzelle an.

Die EMK einer Halbzelle ist jedoch auch über die Temperatur beeinflussbar, ersichtlich aus der der allgemeinen Form der Nernstschen Gleichung:

$$\Delta E = E° + \frac{RT}{zF} \cdot \lg \frac{a_{Ox}}{a_{Red}}$$

mit: $\Delta E$ = elektromotorische Kraft (EMK); E° = Normalpotential (EMK unter Standardbedingungen); R = ideale Gaskonstante = 8,31451 $JK^{-1}mol^{-1}$; T = absolute Temperatur in Kelvin; z = Ladungsäquivalent (Anzahl ausgetauschter Elektronen pro Formeleinheit); F = Faraday-Konstante = 96485 A $\times$ s; $a_{ox}$ und $a_{Red}$ = Konzentrationen der oxidierten und der reduzierten Spezies

Mit steigender Temperatur steigt demnach auch das Reduktionsvermögen der Halbzelle an. Der Nenner des logarithmischen Terms der NERNST'schen Gleichung wird dann relativ zum Zähler größer, weil die Aktivität der Hydroxid-Ionen in der dreifachen Potenz in den Nenner einfließt.

Kinetische Förderung des Redoxprozesses zur Metallabscheidung:

Die Beschleunigung der Reaktionsgeschwindigkeit einer chemischen Reaktion, darunter auch der hier betrachteten Redoxreaktion wird aus der Arrhenius-Beziehung ersichtlich, welche die Geschwindigkeitskonstante k einer Reaktion als eine Funktion der Temperatur beschreibt:

$$k = A \cdot e^{-\frac{E_A}{RT}}$$

mit: k = Geschwindigkeitskonstante, A = reaktionsspezifischer präexponentieller Faktor, $E_A$ = Aktivierungsenergie, R = allgemeine Gaskonstante, T = absolute Temperatur in Kelvin

In der reaktiven Flüssigkeit werden beim Prozess die Konzentrationen der einzelnen Spezies so aufeinander abgestimmt, dass sie unter Standardbedingungen im gegebenen Zeitfenster von der Ansetzung der Lösung bis hin zur Bearbeitung der Oberfläche nicht miteinander reagieren. Hierzu muss die Spannung zwischen den Redox-Systemen $Ni^{2+}/Ni^\circ$ und $HPO_3^{2-}/HPO_4^{2-}$ ausreichend gering gehalten werden, was über die Einstellung des pH-Wertes bzw. der Konzentrationen der beteiligten Spezies in Lösung erfolgen kann.

Strömt nun die Lösung auf die vom Laserstrahl beheizte und geschmolzene Siliciumnitridoberfläche, so laufen dabei nacheinander verschiedene Prozesse ab:

1) Zunächst wird ein Teil der Schmelze durch die Konvektionsströmung ausgetrieben und wegge- spült. Die auf diese Weise entfernte Schmelze ist über eine große aktive Oberfläche dem Ätz- medium Phosphorsäure/ phosphorige Säure ausge- setzt und wird von diesem gelöst, so dass es sich nicht wie beim trockenen Siliciumnitri- dabtrag mit Lasern randständig der Schnittkerbe ablagert. Dadurch entstehen sehr saubere Schnittgruben.

2) So lange eine Siliciumschmelze vorliegt, können die in der Flüssigkeit vorhandenen Phosphor- quellen durch rein thermische Zersetzung den darin enthaltenen Phosphor an das Silicium ab- geben; dieser wird gewissermaßen in das Silici- um eingeschmolzen, ebenso ein Teil der in der Flüssigkeit mitgeführten Metall-Ionen, im vor- liegenden Fall, der Nickel-Ionen. Im geschmol- zenen Silicium ist die Diffusionsrate des Phos- phors darüber hinaus sehr hoch. Der Einbau von Phosphor erfolgt hier umso besser, je geringer dessen Oxidationsstufe ist, weil dann je weni- ger Elektronen vom System auf den Phosphor ü- bertragen werden müssen, der als Dotierstoff im Siliciumkristall elektronegativerer Bindungs- partner gegenüber dem Silicium ist. Durch die Konvektionsströmung die Dotier- und Metalli- siermischung mit der Siliciumschmelze effektiv durchmischt werden, wo sie zusammen mit der Schmelze erstarrt, dadurch eingeschlossen und schließlich in den Siliciumkristall zum Teil direkt eingebaut wird. Auf diese Weise können optional selbst bei einmaligem Überfahren der Schnittkerbe sehr hohe Dotiertiefen von mehre- ren $\mu$m erreicht werden, abhängig von der Schmelztiefe an der Schnittstelle. Ein weiterer Teil der Chemikalienmischung bleibt als Phos- phorsilicatglasinseln unterhalb der Oberfläche eingeschlossen und kann im Rahmen eines Tem- perschrittes als weitere Dotierquelle für das Silicium dienen. Das in sehr großer Menge eben- falls lokal eingeschlossene Nickel legiert da- bei lokal mit dem Silicium zu $Ni_2Si$, wodurch es zur Verringerung des Kontaktwiderstands bei- trägt.

3) Aufgrund der hohen Wärmeleitfähigkeit des Sili- ciums, vor allem im flüssigen Zustand, in dem es metallische Eigenschaften aufweist, klingt die Temperatur des Siliciums relativ schnell ab. Dabei bildet sich auch an der Siliciumo- berfläche ein Phosphorsilicatglas aus, dessen Netzwerkbildner ein dreidimensionales Netz aus Silicium- und Phosphoratomen ist, die über Sau- erstoffbrücken miteinander verbunden sind. Ein statistischer Teil der Sauerstoffatome besitzt nur einen Bindungspartner und eine frei liegen- de Valenz mit einer negativen Ladung. Den La- dungsausgleich hierzu bilden $Ni^{2+}$-Ionen aus der Lösung, die dadurch elektrostatisch an die O- berfläche gebunden werden. Sie können bei einem weiteren Überfahrschritt aus dem Phosphorsili- catglas in die oberste Siliciumschicht diffun- dieren und dort Abscheidkeime für weitere Ni- ckel-Atome bilden. Bei der Dotierung des Sili- ciums mit Hilfe von Phosphorsilicatglas erweist sich hingegen Phosphorsäure gegenüber phospho- riger Säure als die günstigere Phosphorquelle, weil darin alle Valenzen des Phosphors mit Sau- erstoffatomen abgesättigt sind, die zur Netz- werkbildung im Glas benötigt werden.

4) Im Zuge der Abklingens der hohen Temperaturen an der Siliciumoberfläche wird auch jener Tem- peraturbereich durchschritten, bei dem nur noch eine thermische Aktivierung des oben genannten Redoxprozesses zwischen der phosphorigen Säure und den Nickel-Ionen in Lösung erfolgt, nicht aber ein direktes Einschmelzen der Komponenten wie zu Beginn der Prozesses. Jetzt kann durch die in der Schnittkerbe stehende Lösung eine Verdickung der Metallkeimschicht an der Ober- fläche stattfinden, indem oben geschilderte Re- doxreaktion lokal an der bekeimten und hoch do- tierten Siliciumoberfläche abläuft.

Das Phosphorsilicatglas an den Wänden der Schnittkerbe wirkt sich als Isolator nachteilig auf den Kontaktwiderstand der Solarzelle aus, daher muss es im Zuge des Gesamtprozesses wieder entfernt werden, nachdem die Dotierung erfolgt ist. Dies kann parallel zum Dotierungs- und Bekeimungsprozess dadurch geschehen, dass der Reaktionsmischung geringe Mengen an Flusssäure beigemengt werden. In solchen Fällen kann dann jedoch die Verdickung der Keime nicht mit ein und derselben Lösung vorgenommen werden, die für die vorhergehenden Prozessschritte (Nitridabtrag, Dotierung, Bekeimung) eingesetzt wurde, weil in Anwesenheit von Flusssäure eine ausgeprägte Tendenz einer erneuten Auflösung bereits abgeschiedenen, elementaren Metalls gegeben ist. Die Verdickung der Kontakte kann in solchen Fällen im Rahmen eines nachfolgenden Schrittes vollzogen, bei dem mit Hilfe des flüssigkeitsunterstützten Laser-Verfahrens klassische Nickellösungen zur stromlosen Abscheidung von Nickel in die Schnittkerben eingebracht und die Schnittkerben dabei lokal mit Hilfe des Lasers erwärmt werden. Die lokale Abscheidung des Metalls wird dabei durch zwei Faktoren beeinflusst: 1. die hohe Dotierung und bereits vorhandene Bekeimung der Grabenwände, die damit katalytisch wirken und 2. die thermische oder photochemische Aktivierung des Abscheidvorgangs durch den Laser.

Im vorgestellten Beispiel können unter anderem die folgenden Komponentensysteme zum Einsatz kommen:

1) pH = 6,5 $\Rightarrow$ [OH'] = 3,16 x $10^{-7}$ mol/L [$HPO_4^{2-}$] = 5 mol/L [$HPO_3^{2-}$] = $10^{-3}$ mol/L [$Ni^{2+}$] = 5 - 7 mol/L Die Spannung U zwischen Halbzellen $Ni^0\|Ni^{2+}$) und ($HPO_3^{2-}\|HPO_4^{2-}$) beträgt dann +0,205 V

2) pH = 4 $\Rightarrow$ [$OH^-$] = $10^{-10}$ mol/L [$HPO_4^{2-}$] = $10^3$ mol/L [$HPO_3^{2-}$] = 6 mol/L [$Ni^{2+}$] = 5 mol/L Die Spannung U zwischen den Halbzellen ($Ni^0\|Ni^{2+}$) und ($HPO_3^{2-}\|HPO_4^{2-}$) beträgt hier + 0,12 V

3) pH = 6 $\Rightarrow$ [$OH^-$] - $10^{-8}$ mol/L [$HPO_4^{2-}$] = 1 mol/L [$HPO_3^{2-}$] = 5 x $10^{-2}$ mol/L [$Ni^{2+}$] = 1 - 5 mol/L Die Spannung U zwischen den Halbzellen ($Ni^0\|Ni^{2+}$) und ($HPO_3^{2-}\|HPO_4^{2-}$) beträgt in diesem Fall + 0,10 bis +0,12 V

4) pH = 5 $\Rightarrow$ [$OH^-$] = $10^{-9}$ mol/L [$HPO_4^{2-}$]= 1 mol/L [$HPO_3^{2-}$] = $10^{-1}$ mol/L [$Ni^{2+}$] = 1 - 3 mol/L Die Spannung U zwischen den Halbzellen ($Ni^0\|Ni^{2+}$) und ($HPO_3^{2-}\|HPO_4^{2-}$) liegt hier bei +0,04 V

**Beispiel 3**

**Nitridstrukturierung/Dotierung/Bekeimung und Schadensätze mit einem Chemikaliensystem bestehend aus: KOH-Lösung, Hydrogenphosphatsalz, Metallsalz**

Je nach Wahl der Laserwellenlänge können beim Prozessieren der Kontaktgräben Schäden im kristallinen Gefüge mit unterschiedlicher Eindringtiefe entstehen, die aufgrund ihres Qualität mindernden Faktors auf die elektrischen Eigenschaften der Solarzellen unerwünscht sind. Bei den BC-Solarzellen werden diese Schäden nach dem Anfertigen der Gräben durch einen zusätzlichen Schadensätzschritt wieder entfernt, bevor der Metallisierungsschritt durchgeführt wird.

Bei der vorliegenden Erfindung kann diese Schadensätze parallel zu den drei Teilprozessen: Nitridöffnung/ Dotierung/Bekeimung erfolgen, indem das dafür verwendete Chemikaliensystem angepasst wird. An dieser Stelle sei noch einmal auf die Arbeiten von Baumann et al 2006 hingewiesen, in denen gezeigt wurde, dass mit dem flüssigkeitsstrahlgeführten Laser-Verfahren auf der Basis von KOH-Lösungen ein schädigungsfreier Abtrag von Silicium möglich ist. Dies ist auch bei stehender Flüssigkeit zu erwarten. Ausgehend von der Annahme, dass der Nitridabtrag auch weitgehend durch eine rein thermische Ablation des Nitrids durchführbar und eine Metallbekeimung der dotierten Siliciumoberfläche auch ohne Reduktion der Metall-Ionen mit Hilfe einer Phosphorverbindung denkbar ist, lassen sich die in den Ausführungsbeispielen 1 - 2 vorgestellten Chemikaliensysteme dahingehend modifizieren, dass die phosphorhaltigen Verbindungen ausschließlich zur Phosphordotierung eingesetzt werden. Als Phosphorquelle dient in diesem Zusammenhang ein Hydrogenphosphatsalz, z.B. Lithiumhydrogenphosphat, das in einer Kaliumhydroxid-Lösung gelöst ist. Metallquelle ist ein Nickelsalz, z.B. Nickelchlorid. Aufgrund der Tatsache, dass im basischen Bereich Ni(OH)$_2$ ausfällt, muss der Lösung noch ein Komplexbildner für die Nickel-Ionen zugefügt werden, z.B. Ammoniak, mit dem diese den in basischen Medien beständigen [Ni (NH$_3$)$_6$]$^{2+}$$_{(aq)}$ -Komplex bilden.

Dotierung und Bekeimung erfolgen hier wie in Beispiel 2 in den Punkten 1) - 3) beschrieben. Die Schadensätze wird durch Kaliumhydroxid-Ionen vorgenommen, die sich in der überstehenden Lösung in den noch erwärmten Schnittgräben während des Prozesses befinden, während der Laserstrahl weiter gefahren ist. Lithium-Ionen, die beim Schmelz- und Erstarrungsvorgang in den Siliciumkristall ebenfalls lokal an den Kontaktstellen eingebaut werden, reduzieren den Kontaktwiderstand der Solarzelle zusätzlich.

Die Metallkeimschicht kann in einem weiteren Prozessschritt entweder durch klassische stromlose Nickelabscheidung oder durch andere Verfahren verdickt werden, etwa mit Hilfe des Optomec®-Verfahrens.

Im vorgestellten Beispiel können unter anderem die folgenden Komponentensysteme zum Einsatz kommen:

Gehalt der KOH-Lösung: 2 - 20 Gew.-%
[Li$_2$HPO$_4$]= 0,1 - 5 mol/L
[Ni$^{2+}$] = 1 mol/L
ca. 20 mL konz. NH$_3$-Lsg/L Lösung

**Beispiel 4**

**Nitridstrukturierung/Dotierung und Schadensätze ohne Metallbekeimung mit Chemikaliensystemen aus Phosphorsäure/Salpetersäure/Flusssäure**

Wird auf eine Metallbekeimung im Zuge der Nitridstrukturierung und gleichzeitiger Dotierung verzichtet und diese erst in einem anschließenden Schritt durchgeführt, so kann als Schadensätzreagenz ein Gemisch aus HF/HNO$_3$ eingesetzt werden, das der Phosphorsäure zugesetzt wird. HF/HNO$_3$ hat gegenüber KOH als Schadensätzreagenz den Vorteil einer viel höheren Ätzrate und isotroper Ätzeigenschaften.

Im vorgestellten Beispiel können unter anderem die folgenden Komponentensysteme zum Einsatz kommen:

Gehalt der Phosphorsäure-Lösung: 80 - 87 Gew.-%
HF (49%) : 35 mL/L Lösung
HNO$_3$ (70%) : 15 mL/L Lösung

**Patentansprüche**

1. Verfahren zur simultanen Mikrostrukturierung, Dotierung und zumindest bereichsweisen Aufbringung einer Keimschicht von Substraten, bei dem ein auf eine Substratoberfläche gerichteter Laserstrahl über die zu bearbeitenden Bereiche des Substrats geführt wird, wobei das Substrat zumindest an den zu bearbeitenden Bereichen des Substrates von einer ein Bearbeitungsreagenz enthaltenden Flüssigkeit bedeckt ist,
   **dadurch gekennzeichnet, dass** als Bearbeitungsreagenz ein Ätzmittel, ein Dotierstoff, mindestens eine Metallverbindung und ein Reduktionsmittel in der Flüssigkeit enthalten sind.

2. Verfahren nach einem der vorhergehenden Ansprüche,
   **dadurch gekennzeichnet, dass** das Substrat ausgewählt ist aus der Gruppe bestehend aus Silicium, Glas, Metall, Keramik, Kunststoff und deren Verbunden.

3. Verfahren nach einem der vorhergehenden Ansprüche,
   **dadurch gekennzeichnet, dass** der Laserstrahl in zeitlicher und/oder räumlicher Pulsform, insbesondere Flattop-Form, M-Profil oder Rechteckpuls, aktiv eingestellt wird.

4. Verfahren nach einem der vorhergehenden Ansprüche,
   **dadurch gekennzeichnet, dass** der Dotierstoff ausgewählt ist aus der Gruppe bestehend aus Phosphor-, Bor-, Gallium-, Stickstoff-, Arsen- und Antimonverbindungen und Mischungen hiervon, insbesondere POCl$_3$, in einen Silicium-Wafer als Substrat zur zumindest bereichsweisen Dotierung des Substrats durchgeführt wird.

5. Verfahren nach einem der vorhergehenden Ansprüche,
   **dadurch gekennzeichnet, dass** vor der Präzisionsbearbeitung mindestens eine dielektrische Schicht, insbesondere ausgewählt ist aus der Gruppe bestehend aus SiN$_x$, SiO$_2$, SiO$_x$, MgF$_2$, TiO$_2$ und SiC$_x$ auf dem Substrat zur Passivierung abgeschieden wird.

6. Verfahren nach Anspruch 5,
   **dadurch gekennzeichnet, dass** bei der Präzisionsbearbeitung eine Mikrostrukturierung der dielektrischen Schicht erfolgt, insbesondere indem die dielektrische Schicht durch Behandlung mit einem trockenen Laser oder einem wasserstrahlgeführten Laser geöffnet wird und/oder die dielektrische Schicht durch Behandlung mit dem Laser geöffnet wird und das Bearbeitungsreagenz ein Ätzmittel ist, das auf die dielektrische Schicht eine stärker ätzende Wirkung als auf das Substrat besitzt.

7. Verfahren nach einem der Ansprüche 5 oder 6,
   **dadurch gekennzeichnet, dass** die dielektrische Schicht durch Behandlung mit dem Laser geöffnet wird und dass das Bearbeitungsreagenz ein Ätzmittel, insbesondere ausgewählt aus der Gruppe bestehend aus H$_3$PO$_4$, KOH, HF/HNO$_3$, Chlorverbindungen und Schwefelsäure, ist, mit dem Schäden im Substrat nachgeätzt werden.

8. Verfahren nach einem der vorhergehenden Ansprüche,
   **dadurch gekennzeichnet, dass** das Ätzmittel und das Reduktionsmittel ein und dasselbe chemische Element in unterschiedlichen Oxidationsstufen enthalten.

**9.** Verfahren nach einem der vorhergehenden Ansprüche,
**dadurch gekennzeichnet, dass** das Reduktionsmittel ein Aldehyd enthält.

**10.** Verfahren nach einem der vorhergehenden Ansprüche,
**dadurch gekennzeichnet, dass** die Flüssigkeit ein Metallsalz, insbesondere ein Silber-, Nickel-, Aluminium- oder Chromsalz enthält, wobei das Nickelsalz bevorzugt ein Nickelchlorid $NiCl_2$, ein Nickelsulfat $NiSO_4$ oder ein Nickelnitrat $Ni(NO_3)_2$ ist.

**11.** Verfahren nach einem der vorhergehenden Ansprüche,
**dadurch gekennzeichnet, dass** bei der Präzisionsbearbeitung nur bereichsweise eine Dotierung im Substrat erzeugt wird, anschließend auf der Substratoberfläche befindliche Flüssigkeit eingetrocknet und das Substrat thermisch behandelt wird, so dass das Substrat eine schwache Flächendotierung und eine eingetriebene hohe Lokaldotierung aufweist.

**12.** Verfahren nach einem der vorhergehenden Ansprüche,
**dadurch gekennzeichnet, dass** die zumindest bereichsweise Aufbringung einer Keimschicht durch Nickel-Galvanisierung, Nickel-Laser-Verfahren, Inkjet-Verfahren, Aerosol-Verfahren, Aufdampfen, Lasermikrosintern, Siebdruck und/oder Tampondruck erfolgt.

**13.** Verfahren nach einem der vorhergehenden Ansprüche,
**dadurch gekennzeichnet, dass** die mindestens eine Metallverbindung ausgewählt ist aus der Gruppe der Verbindungen von Silber, Aluminium, Nickel, Titan, Molybdän, Wolfram und Chrom, insbesondere Silbercyanid, Silberacetat oder Silbernitrat ist.

**14.** Verfahren nach einem der vorhergehenden Ansprüche,
**dadurch gekennzeichnet, dass** die Keimschicht auf den dotierten Bereichen des Silicium-Wafers aufgebracht wird.

**15.** Verfahren nach einem der vorhergehenden Ansprüche,
**dadurch gekennzeichnet, dass** nach der Aufbringung der Keimschicht eine Rückseitenkontaktierung, insbesondere durch Aufdampfen oder Sputtern oder durch lasergefeuerte Rückseitenkontaktierung (LFC), aufgebracht wird.

**16.** Verfahren nach einem der vorhergehenden Ansprüche,
**dadurch gekennzeichnet, dass** nach der Aufbringung der Keimschicht eine zusätzliche Rückseitenkontaktierung durch lasergefeuerte Rückseitenkontaktierung (LFC) aufgebracht wird.

**17.** Verfahren nach einem der vorhergehenden Ansprüche,
**dadurch gekennzeichnet, dass** nach der Aufbringung der Keimschicht eine thermische Behandlung, insbesondere durch Laser-Annealing mit Punkt- oder Linienfokus und insbesondere bei Temperaturen von 100 °C bis 900 °C, erfolgt.

**18.** Verfahren nach einem der vorhergehenden Ansprüche,
**dadurch gekennzeichnet, dass** nach der Präzisionsbearbeitung im Anschluss an das Aufbringen der Keimschicht eine Verdickung, insbesondere durch galvanische Abscheidung, z.B. von Ag, oder durch stromlose Abscheidung, z.B. von Cu, der Keimschicht erfolgt.

**Claims**

**1.** Method for the simultaneous microstructuring, doping and at least partial deposition of a nucleation layer of substrates, in which a laser beam directed towards a substrate surface is guided over the regions of the substrate to be processed, the substrate being covered at least at the regions of the substrate to be processed by a liquid containing a processing reagent, **characterized in that** the liquid comprises an etching agent, a dopant, at least one metal compound and a reduction agent as the processing agent.

**2.** Method according to one of the preceding claims,
wherein the substrate is selected from the group consisting of silicon, glass, metal, ceramic, plastic material and composites thereof.

3. Method according to one of the preceding claims,
wherein the laser beam is adjusted actively in temporal and/or spatial pulse form, in particular flat top form, M-profile or rectangular pulse.

4. Method according to one of the preceding claims,
wherein the dopant is selected from the group consisting of phosphorus-, boron-, gallium-, nitrogen-, arsenic- and antimony-compounds and mixtures hereof, preferably $POCl_3$, in a silicon wafer as substrate for at least partial doping of the substrate.

5. Method according to one of the preceding claims, wherein, before the precision processing, at least one dielectric layer, preferably selected from the group consisting of $SiN_x$, $SiO_2$, $SiO_x$, $MgF_2$, $TiO_2$ or $SiC_x$, is deposited on the substrate for passivation.

6. Method according to claim 5,
wherein, during the precision processing, a microstructuring of the dielectric layer is effected, in particular wherein the dielectric layer is opened by treatment with a dry laser or a waterjet-guided laser and/or the dielectric layer is opened by treatment with the laser and the processing reagent is an etching agent which has a stronger etching effect on the dielectric layer than on the substrate.

7. Method according to one of the claims 5 or 6,
wherein the dielectric layer is opened by treatment with the laser and the processing reagent is an etching agent, preferably selected from the group consisting of $H_3PO_4$, KOH, HF/$HNO_3$, chlorine compounds and sulphuric acid, with which damages to the substrate are etched subsequently.

8. Method according to one of the preceding claims, wherein the etching agent and the reduction agent contain one and the same chemical element in different oxidation stages.

9. Method according to one of the preceding claims, wherein the reduction agent contains an aldehyde.

10. Method according to one of the preceding claims, wherein, the liquid comprises a metal salt, in particular a silver, nickel, aluminium or chromium salt and wherein the nickel salt preferably is a nickel chloride $NiCl_2$, a nickel sulphate $NiSO_4$ or a nickel nitrate $Ni(NO_3)_2$.

11. Method according to one of the preceding claims, wherein doping is produced in the substrate only in regions during the precision processing, subsequently liquid located on the substrate surface dries in and the substrate is treated thermally so that the substrate has a weak surface doping and high local doping introduced.

12. Method according to one of the preceding claims, wherein, during the precision processing, application of a nucleation layer is effected at least in regions on a silicon wafer by nickel galvanisation, nickel-laser methods, inkjet methods, aerosol methods, vapour deposition, laser microsintering, screen printing and/or tampon printing.

13. Method according to one oft he preceding claims, wherein the at least one metal compound is selected from the group of compounds of silver, aluminium, nickel, titanium, molybdenum, tungsten and chromium, particularly silver cyanide, silver acetate or silver nitrate.

14. Method according to one of the preceding claims, wherein the nucleation layer is applied on the doped regions of the silicon wafer.

15. Method according to one of the preceding claims, wherein, after application of the nucleation layer, a rear-side contacting, in particular by vapour deposition or sputtering or by laser-fired rear-side contacting (LFC), is applied.

16. Method according to one of the preceding claims, wherein, after application of the nucleation layer, an additional rear-side contacting is applied by means of laser-fired rear-side contacting (LFC).

17. Method according to one of the preceding claims, wherein, after application of the nucleation layer, a thermal treatment is effected, in particulary by means of laser annealing with point or line focus and in particular at temperatures of 100°C to 900°C.

**EP 2 134 887 B1**

**18.** Method according to one of the preceding claims, wherein, after the precision processing and subsequent to the application of the nucleation layer, thickening of the nucleation layer is effected, in particular by galvanic deposition, e.g. of Ag, or by currentless deposition, e.g. of Cu.

**Revendications**

**1.** Procédé de réalisation simultanée d'une microstructuration, d'un dopage et d'un report, au moins par zones, d'une couche germe de substrat hôte, dans lequel on dirige un faisceau laser, pointé sur une surface du substrat, par-dessus les zones à traiter du substrat, lequel substrat est recouvert, au moins dans les zones du substrat à traiter, d'un liquide contenant un réactif de traitement,
**caractérisé en ce que** le liquide contient comme réactif de traitement un agent de gravure, un dopant, au moins un composé métallique et un réducteur.

**2.** Procédé selon l'une quelconque des revendications précédentes,
**caractérisé en ce que** le substrat est choisi dans le groupe constitué de silicium, de verre, de métal, de céramique, de synthétique et de leurs composés.

**3.** Procédé selon l'une quelconque des revendications précédentes, **caractérisé en ce que** le faisceau laser à impulsions temporelles et/ou spatiales, en particulier impulsions à sommet plat (de profil flat-top), impulsions M ou impulsions rectangulaires, est réglé en mode actif.

**4.** Procédé selon l'une quelconque des revendications précédentes,
**caractérisé en ce que** le dopant est choisi dans le groupe constitué des composés de phosphore, de bore, de gallium, d'azote, d'arsenic et d'antimoine et des mélanges de ceux-ci, en particulier le $POCl_3$, **en ce que** l'on réalise un dopage, au moins par zones, du substrat dans un wafer de silicium servant de substrat.

**5.** Procédé selon l'une quelconque des revendications précédentes, **caractérisé en ce que**,
avant le traitement de précision, au moins une couche diélectrique, en particulier choisie dans le groupe constitué de $SiN_x$, $SiO_2$, $SiO_x$, $MgF_2$, $TiO_2$ et $SiC_x$, vient se déposer sur le substrat pour sa passivation.

**6.** Procédé selon la revendication 5,
**caractérisé en ce que**, lors du traitement de précision, on obtient une microstructuration de la couche diélectrique, en particulier en ouvrant la couche diélectrique par traitement avec un laser à sec ou un laser à jet d'eau et/ou en ouvrant la couche diélectrique par traitement avec le laser et un agent de gravure comme réactif de traitement, dont l'effet corrosif est plus puissant sur la couche diélectrique que sur le substrat.

**7.** Procédé selon l'une quelconque des revendications 5 ou 6,
**caractérisé en ce que** la couche diélectrique est ouverte par traitement avec le laser et **en ce que** le réactif de traitement est un agent de gravure, choisi, en particulier, dans le groupe constitué de $H_3PO_4$, KOH, $HF/HNO_3$, des composés de chlore et de l'acide sulfurique, servant au retraitement par gravure afin de traiter les dommages du substrat.

**8.** Procédé selon l'une quelconque des revendications précédentes,
**caractérisé en ce que** le agent de gravure et le réducteur comportent exactement le même élément chimique à différents degrés d'oxydation.

**9.** Procédé selon l'une quelconque des revendications précédentes,
**caractérisé en ce que** le réducteur contient un aldéhyde.

**10.** Procédé selon l'une quelconque des revendications précédentes,
**caractérisé en ce que** le liquide contient un sel métallique, en particulier un sel d'argent, de nickel, d'aluminium ou de chrome, le sel de nickel étant de préférence un chlorure de nickel $NiCl_2$, un sulfate de nickel $NiSO_4$ ou un nitrate de nickel $Ni(NO_3)_2$.

**11.** Procédé selon l'une quelconque des revendications précédentes,
**caractérisé en ce que**, lors du traitement de précision, on ne réalise un dopage dans le substrat que par zones, **en ce que** l'on fait sécher ensuite le liquide qui se trouve sur la surface du substrat et **en ce que** l'on soumet le

19

substrat à un traitement thermique de sorte que le substrat présente un faible dopage des surfaces et un dopage localisé élevé par implantation.

12. Procédé selon l'une quelconque des revendications précédentes, **caractérisé en ce que** le report d'une couche germe, au moins par zones, est réalisé en utilisant des procédés de nickelage galvanique, de nickelage par laser, de jet d'encre, d'aérosol, de métallisation sous vide, de microfrittage par laser, de sérigraphie et/ou de tampographie.

13. Procédé selon l'une quelconque des revendications précédentes, **caractérisé en ce qu'**au moins un composé métallique est choisi dans le groupe des composés d'argent, d'aluminium, de nickel, de titane, de molybdène, de tungstène et de chrome, en particulier du cyanure d'argent, de l'acétate d'argent ou du nitrate d'argent.

14. Procédé selon l'une des revendications précédentes, **caractérisé en ce que** la couche germe est reporté sur les zones dopées du wafer de silicium.

15. Procédé selon l'une quelconque des revendications précédentes, **caractérisé en ce que**, après le report de la couche germe, on réalise des contacts en face arrière, en particulier par métallisation sous vide ou pulvérisation cathodique ou procédé LFC (laser fired contacts) en face arrière.

16. Procédé selon l'une quelconque des revendications précédentes, **caractérisé en ce que**, après le report de la couche germe, on procède à une réalisation supplémentaire de contacts en face arrière par procédé LFC (laser fired contacts) en face arrière.

17. Procédé selon l'une quelconque des revendications précédentes, **caractérisé en ce que**, après le report de la couche germe, on effectue un traitement thermique, en particulier par recuit de laser à foyer ponctuel ou linéaire et en particulier à des températures allant de 100°C à 900°C.

18. Procédé selon l'une quelconque des revendications précédentes, **caractérisé en ce que**, après le traitement de précision et à la suite du report de la couche germe, on obtient un épaississement de la couche germe, en particulier par déposition galvanique, de par exemple Ag, ou par déposition autocatalytique, de par exemple Cu.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5059449 A
- US 20040242019 A1
- DE 102005032807 A1

**In der Beschreibung aufgeführte Nicht-Patentliteratur**

- **Ametowobla M. ; Esturo-Bretön A. ; Köhler J.R. ; Werner J.H.** Laser Processing of Silicon Solar Cells. *IEEE,* 2005
- **Pearlstein, F.** Electroless Plating in: ''Modern Electroplating''. Wiley, 1974, 710-744
- **Wang J. ; Xudong F. ; Zuzhan Y. ; Zhao G.** Laser-induced selective deposition of Ni-P alloy on silicon. *Applied Surface Science,* 1995, vol. 84, 383-389
- **Green M.A. ; Wenham S.R. ; Zhao J. ; Bowden S. ; Milne A.M. ; Taouk M. ; Zhang F.** Present Status of Buried Contact Solar Cells. *IEEE Transactions on Electron Devices,* 1991, 46-53